# EUROPÄISCHE PATENTANMELDUNG

(11) **EP 1 870 387 A1**
(43) Veröffentlichungstag der Anmeldung: **26.12.2007**
(21) Anmeldenummer: 07011883.1
(22) Anmeldetag: 18.06.2007
(51) Int. Cl.: C03C 21/00, C03C 23/00, C03C 17/245

(54) **Verfahren zur Modifizierung der Oberflächeneigenschaften von Glas**

(30) Priorität: 23.06.2006 DE 102006029617
(71) Anmelder: Verein zur Förderung von Innovationen durch Forschung, Entwicklung und Technologietransfer e.V. (Verein INNOVENT e.V.), 07745 Jena (DE)
(72) Erfinder: Grünler, Bernd Dr., 07937 Zeulenroda (DE); Weidl, Roland Dr., 07646 Bollberg (DE); Gitter, Uwe, 07629 Hermsdorf (DE)
(74) Vertreter: Oehmke, Volker

(57) **Zusammenfassung**

Die Erfindung betrifft ein Verfahren zur Modifizierung der Oberflächeneigenschaften von Glas.

Der Erfindung liegt die Aufgabe zugrunde, ein Verfahren anzugeben, mit dem bei einfacher Handhabung die Oberfläche von Glas modifiziert werden kann.

Die Aufgabe wird durch das vorliegende erfindungsgemäße Verfahren zur Modifizierung von Gläsern im oberflächennahen Bereich dadurch gelöst, dass chemische Substanzen (sogenannte Precursoren) von Metallen und

Metallverbindungen, vorzugsweise aber nicht ausschließlich von Aluminium, Titan, Gold, Silber, Kupfer, Zink sowie allgemein von Elementen der 3. - 5. Hauptgruppe und der 1. - 8. Nebengruppe sowie Schwefel mittels einer Brenner-Einrichtung auf heißes Glas (vorzugsweise im Bereich der Transformationstemperatur) einwirken.

## Beschreibung

Die Erfindung betrifft ein Verfahren zur Modifizierung der Oberflächeneigenschaften von Glas.

Insbesondere im Hinblick auf die Wechselwirkung zwischen Glas und seiner Umwelt spielt die Oberflächengestaltung bekanntermaßen ein große Rolle. Gleiches trifft grundsätzlich ganz allgemein auf die Eigenschaften von Glas zu. Der Weg, um die Eigenschaften von Gläsern zu beeinflussen, geht einerseits über den Glasherstellungsprozess selbst und andererseits über den Weg der Beschichtung von Oberflächen von Gläsern. Das Aufbringen von Schichten bringt generell das Problem mit sich, dass ihre funktionelle Wirkung nur erfolgreich und/oder langlebig gegeben ist, wenn die Schichten besonders haftfest und für bestimmte Anwendungsfälle auch homogen aufgetragen sind. Mit der DE 103 19 708 A1 wird ein Verfahren zur Herstellung alkalihaltiger Gläser zu Modifizierung der Oberfläche vorgestellt. Hierbei soll die Oberfläche in Kontakt mit erhöhten Aluminiumkonzentrationen gebracht werden. Die vorgeschlagenen Lösungen durch Tauchen, Spritzen oder Dampf sind in der Handhabung unpraktikabel und garantieren darüber hinaus keine homogene Gestaltung der Oberfläche.

Der Erfindung liegt die Aufgabe zugrunde, ein Verfahren anzugeben, mit dem bei einfacher Handhabung die Oberfläche von Glas modifiziert werden kann

Die Aufgabe wird durch das vorliegende erfindungsgemäße Verfahren zur Modifizierung von Gläsern im oberflächennahen Bereich dadurch gelöst, dass chemische Substanzen (sogenannte Precursoren) von Metallen und Metallverbindungen, vorzugsweise aber nicht ausschließlich von Aluminium, Titan, Gold, Silber, Kupfer, Zink sowie allgemein von Elementen der 3. - 5. Hauptgruppe und der 1. - 8. Nebengruppe sowie Schwefel mittels einer Brenner-Einrichtung auf heißes Glas (vorzugsweise im Bereich der Transformationstemperatur) einwirken. Ebenfalls sind Kombinationen von diesen Precursoren möglich. Als Brennstoff kommen hier alle gängigen Gase in Frage wie Erdgas, Acetylen, Butan, etc., vorzugsweise jedoch Propan.

Denkbar ist es auch, die Glasoberfläche durch den Einsatz der Brenner selbst quasi in-situ auf die geeignete Temperatur zu bringen (möglicher Anwendungsfall beispielsweise aber nicht ausschließlich Glasfasern).
Bei dem erfindungsgemäßen Verfahren entsteht hierbei, nicht wie man erwarten würde, eine Schicht auf der Oberfläche des Glases, sondern vielmehr durch geeignete Wahl der Parameter eine Dotierung in Form einer Gradientendiffusion in das Material hinein, wodurch sich die Eigenschaften ändern (vorzugsweise die Härte und die Barrierewirkung bezüglich Diffusion von anderen Elementen vorzugsweise von Alkalimetallen) aber auch zur Erzeugung von photokatalytisch aktiven Oberflächen, gefärbten Oberflächen, hydrophilen Oberflächen, hydrophoben Oberflächen, optisch aktiven Oberflächen, antibakteriellen Oberflächen, allgemein funktionellen Oberflächen).

Als Substrat ist vorzugsweise, aber nicht ausschließlich, Flachglas verwendbar, des Weiteren Hohlglas, strukturiertes Glas, beschichtetes Glas, Glasfasern, Quarzglas, Borofloatglas sowie Erzeugnisse aus Glas wie z.B. Lampenkörper.

Um das Aufschmelzen der Glas- bzw. sonstigen Oberflächen zu begünstigen, kann ein erhöhter Energieeintrag über den Brenner durch Verwendung energiereicher Brennergase wie organische Brenngase (z. B. Propan/Butan/ Acetylen + Sauerstoff + sauerstoffangereicherte Luft als auch durch Wasserstoff/Sauerstoffflammen sowie durch Plasmabrenner) erfolgen. Diese Brenner können mit den Precursoren dotiert werden, als auch separat in Kombination mit einem precursordotierten Brenner, der eine andere Gaszusammensetzung haben kann, verwendet werden.

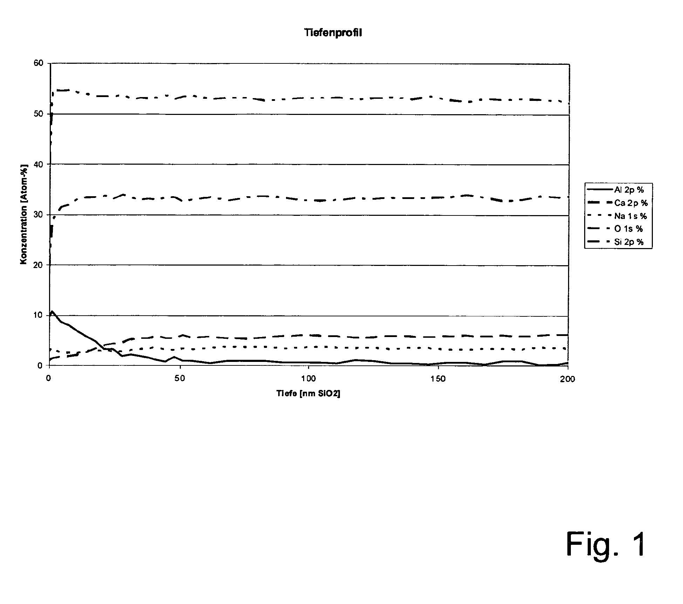

Nachfolgend soll anhand von Ausführungsbeispielen die Erfindung anhand von Zeichnungen näher erläutert werden. Dabei zeigt
Fig. 1 ein Tiefenprofil einer erfindungsgemäß modifizierten Oberfläche eines Glases

Floatglasscherben wurden im Ofen für 15 Minuten bei 1380 °C aufgeschmolzen zu einer Probe mit ca. 8 cm Durchmesser. Anschließend wurde die Temperatur der heißen Probe gemessen und bei 650 °C wurde die Oberfläche mittels eines Propan-Luft-Brenners 30 Sekunden lang in zyklischen Bewegungen behandelt. In die Zuleitung zum Propan-Luft-Brenner wurde die chemische Substanz (der Precursor) mittels einer Pumpe eindosiert, derart, dass der Precursor in flüssiger Form über eine Düse in das Brenngasluftgemisch gesprüht wurde, bevor er den Brenner erreicht. Die folgenden Parameter wurden dabei verwendet:
- Precursor: (AlCl₃ * 6 H₂O) / Methanol im Verhältnis 1:10
- Brenner: 55 l/min Luft, 3,5 l/min Propan
- Abstand Brenner Probe: 20 mm
- Brennertyp: B1-100 Firma Arcogas GmbH
- Fördermenge 1,7 ml/min
Anschließend wurde die noch heiße Probe in einen Muffelofen gegeben, der sich auf 540 °C befand und kontrolliert abgekühlt auf Raumtemperatur, um Spannungsrisse zu vermeiden.
Wie aus Fig. 1 zu entnehmen ist, zeigt eine XPS Messung an einer auf diese Art hergestellten Probe eine Gradientendiffusion bis in ca. 50 nm Tiefe in die Glasscheibe hinein. Die gemessene Leitfähigkeit der erfindungsgemäß behandelten Probe fiel von 15,4 µS (unbehandelt) auf 6,2 µS.

### Vorteile des erfindungsgemäßen Verfahrens gegenüber anderen Verfahren:

Die Behandlung mittels einer Brennereinrichtung erzielt homogenere Ergebnisse als die Behandlung mittels Aufspritzen einer Flüssigkeit, denn der bereits im Brenngas fein verteilte Precursor wird im heißen Flammenplasma weiter verteilt und die verwendeten Brenner sind auf ein homogenes Flammenbild und somit eine homogene Behandlungsfläche optimiert.

Die verwendete Technologie ist im Vergleich zur Behandlung mit der Dampfphase erstens von der Geräteseite her sehr einfach zu realisieren und zweitens im Prozess technisch auch einfacher zu handhaben. Bei der Oberflächenbehandlung mit der Dampfphase stellt die Lagerung/bzw. Dosierung ein Problem dar und insbesondere der Transport, denn der Dampf kann kondensieren, so dass Aluminiumchlorid wieder ausfällt, was fatale Folgen für den kontrollierten Abscheidungsprozess hat.

Es ist keine thermische Nachbehandlung nach dem Aufbringen notwendig.
Die Skalierbarkeit ist von Vorteil, d.h. auf die Breite einer Floatglaslinie (Europa 3.2 m) zu kommen ist anlagentechnisch von der Brennerseite aus kein Problem.

Die Flamme bringt einen zusätzlichen Energieeintrag, von dem man annehmen kann, dass er möglicherweise die Diffusion der aktivierten Spezies positiv beeinflusst oder es ermöglicht, im Temperaturbereich des Glases weiter zu tieferen Temperaturen zu gehen. Dies heißt beispielsweise für die Anwendung in der Praxis eine Position weiter vom heißen Ende der Floatlinie entfernt.

Bei der Verbrennung von Propan an Luft entsteht Wasser, was gegebenenfalls zu einer Verbesserung der Eigenschaften der Systeme beitragen kann.

Denkbar ist es auch, die Behandlung auf Glasfäden (Glaskord) durchzuführen, entweder direkt bei der Herstellung auf dem noch heißen Kord (bzw. auf den Filamenten) oder nachträglich, da der Hitzeeintrag des Brenners hier ausreichen könnte (abhängig von anderen Parametern wie Geschwindigkeit, etc.).

Die Tiefe der Diffusion sowie der Gradient der Aluminiumverteilung sind durch Prozessparameter steuerbar.

## Patentansprüche

1. Verfahren zur Modifizierung der Oberflächeneigenschaften von Glas,
**dadurch gekennzeichnet,**
**dass** die Oberfläche des Glases mit einem Brenner behandelt wird, wobei dem Brenngas Precursoren beigemischt wurden.
